Europäisches Patentamt

European Patent Office

Office européen des brevets

(11) Publication number: **0 259 377**
**B1**

# EUROPEAN PATENT SPECIFICATION

(45) Date of publication of patent specification: **27.12.90**

(51) Int. Cl.⁵: **H 05 K 7/20**

(21) Application number: **87901225.0**

(22) Date of filing: **27.01.87**

(86) International application number:
**PCT/US87/00160**

(87) International publication number:
**WO 87/05174 27.08.87 Gazette 87/19**

(54) MOUNTING SYSTEM FOR AN ELECTRONIC DEVICE.

(30) Priority: **18.02.86 US 830027**

(43) Date of publication of application:
**16.03.88 Bulletin 88/11**

(45) Publication of the grant of the patent:
**27.12.90 Bulletin 90/52**

(84) Designated Contracting States:
**AT BE CH DE FR GB LI**

(56) References cited:
**EP-A-0 129 966**
**FR-A-2 238 314**
**GB-A-2 107 526**
**US-A-4 358 173**

(73) Proprietor: **NCR CORPORATION**
**World Headquarters**
**Dayton, Ohio 45479 (US)**

(72) Inventor: **SPERAW, Floyd, Gibson**
**303 Rollingwood Drive**
**Lexington, SC 29072 (US)**
Inventor: **CABANISS, Frank, Wayne**
**1400 Creekview Drive**
**Columbia, SC 29210 (US)**

(74) Representative: **Robinson, Robert George**
**International Patent Department NCR Limited**
**206 Marylebone Road**
**London NW1 6LY (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a mounting system for an electronic device which is electrically connected to a printed circuit board, and is concerned in particular with such a system which includes means for conducting heat from the electronic device to a heat sink.

In the design of certain types of electronic equipment, such as power converters it is necessary to provide means for cooling electronic devices included in the equipment during operation of the equipment. Problems have been experienced in achieving a mounting and cooling system for electronic devices which is of simple construction and efficient as regards heat transfer.

In the U.S. Patent No. 4,535,385, for example, there is disclosed a mounting system for a pair of printed circuit boards wherein a cooling plate is disposed between the two boards, a number of electronic devices being mounted on that side of each board remote from the cooling plate. Thermally conductive flow paths extend through the printed circuit boards for providing a thermal connection between the electronic devices and the cooling plate. The cooling plate is connected to the chassis of a computer or other electronic equipment, and heat is transferred in operation from the cooling plate to the chassis. The fact that the electronic devices are not directly affixed to the cooling plate detracts from the efficiency of the heat transfer between the electronic devices and the cooling plate, and gives rise to some constructional complexities.

It is an object of the invention to provide a mounting system for an electronic device electrically connected to a printed circuit board, which system is of simple construction and incorporates efficient means for transferring heat away from the electronic device.

According to the invention there is provided a mounting system for an electronic device which is electrically connected to a printed circuit board, the system including means for conducting heat from said electronic device to a chassis, characterized by a metallic plate to which said electronic device is affixed, said electronic device being positioned between said plate and said printed circuit board, and having electrical conductors which extend from said device away from said plate, said printed circuit board being provided with electrical receptacles arranged to receive and to be electrically engaged by said conductors, first and second heat transfer devices each incorporating a cross-bar member and a leg member, said cross-bar member of each heat transfer device being disposed between said plate and said board, and said leg member of each heat transfer device extending through an opening in said board and abutting against said chassis, first fastening means for attaching said board to said cross-bar member of each heat transfer device, and further fastening means for attaching said leg member of each heat transfer device to said chassis, and for attaching said crossbar member of each heat transfer device to said plate, whereby heat is conducted in operation from said electronic device to said chassis via said plate and said first and second heat transfer devices.

It should be appreciated that in a mounting system in accordance with the present invention more than one electronic device may be affixed to the said metallic plate. Also, it should be appreciated that more than one metallic plate, each having one or more electronic devices affixed thereto, may be included in the system, each plate being associated in a similar manner with at least two heat transfer devices which serve to conduct heat from the relevant electronic device or devices to the chassis.

Brief Description of the Drawings

One embodiment of the invention will now be described by way of example with reference to the accompanying drawings in which:

Fig. 1 is a partially exploded perspective, view of a power converter utilizing a mounting system in accordance with the present invention;

Fig. 2 is a top view, partly in section, of the power converter of Fig. 1;

Fig. 3 is a perspective view of a heat transfer device utilized in the power converter; and

Fig. 4 is an enlarged, fragmented, view of a portion of the power converter viewed along the direction of the arrow B in Fig. 1.

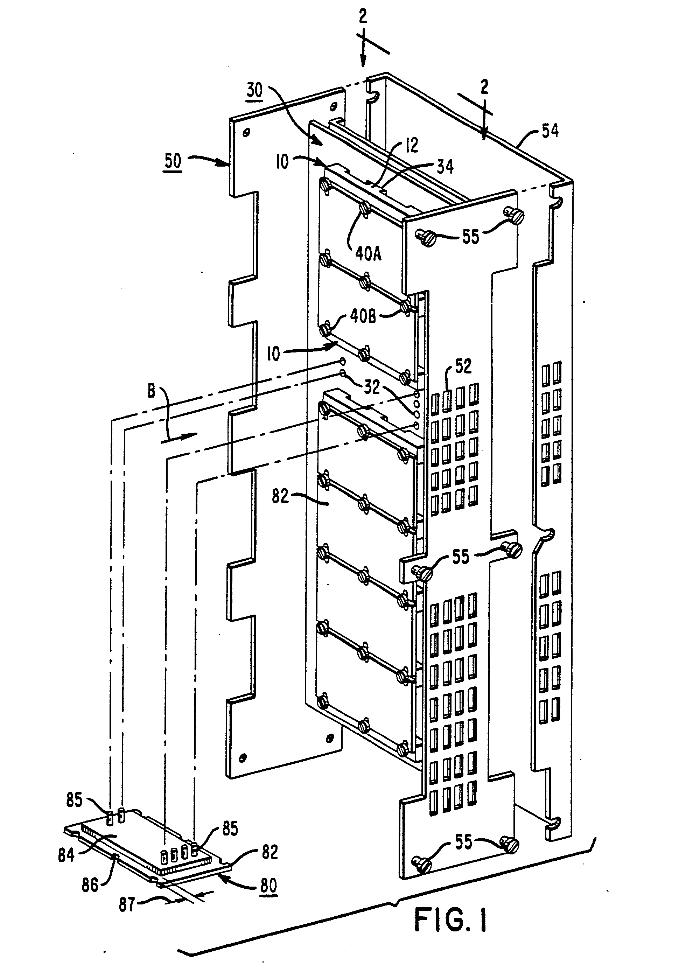

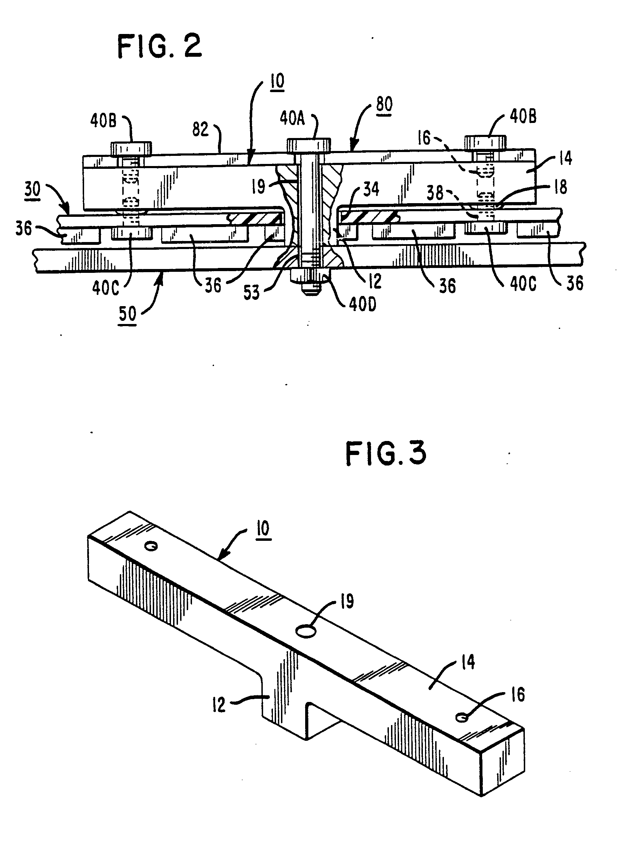

Best Mode for Carrying Out the Invention Referring to Figs. 1 and 2, a metal chassis 50 functions as a heat sink and as a structural base for supporting a printed circuit board 30 and a plurality of electronic modules 80. A plurality of heat transfer devices 10, each formed in the shape of a "T", are affixed to the chassis 50 for supporting the printed circuit board 30 and the electronic modules 80 and for conducting heat from the modules 80 to the chassis 50. Each electronic module 80 is comprised of a metal back plate 82 and an electronic device in the form of a block of encapsulated electronic components 84, having electrical connectors 85 projecting from the surface opposite the back plate 82, the block 84 being affixed to, and in thermal contact with, the plate 82.

The width of the back plate 82, as compared to the block of encapsulated components 84, is such that a lip 87 is provided on each side of the block 84 for engaging approximately one-half the width of the upper surface of a cross-bar member 14 of an associated heat transfer device 10 (see Fig. 2 and Fig. 3). Notches 86, in the back plate 82, are provided for receiving fasteners 40A and 40B.

Provided in the printed circuit board 30 are electrical receptacles 32 for receiving and electrically engaging with the electrical connectors 85 of the electronic modules 80.

A leg 12 of each "T" shaped heat transfer device 10 extends through a respective opening 34 in the printed circuit board 30 to abut against the chassis 50. The fasteners 40A affix the heat transfer devices 10, the modules 80, and the printed circuit board 30 to the chassis 50. If needed, air may be passed through a plurality of chassis openings 52 to provide additional cooling to the chassis supported electrical components. Two identical cover plates 54 (only one shown for simplicity) are affixed to the main chassis by sheet metal screws 55. The covers provide an air chamber through which cooling air passes in operation.

Referring to Fig. 2, in conjunction with Fig. 3, each heat transfer device 10 is formed as a truncated T-bar with a cross-bar member 14 and a short leg member 12. Extending through the cross-bar member 14 and the leg member 12 is a hole 19 for receiving a fastener 40A, in the form of a bolt and which extends through the hole 19 and a corresponding hole 53, in the chassis 50, to engage a nut 40D. The nut 40D may be replaced with a screw type insert, formed in opening 53, for receiving the fastener 40A. The top plate 82 of an associated module 80 fits under the fastener 40A, in the area of a slot 86. The fastener 40A when tightened, rigidly secures the module 80 to the heat transfer device 10 and the heat transfer device 10 to the chassis 50. The printed circuit board 30 is provided with openings 34 to permit the legs 12 of the heat transfer devices 10 to pass through the printed circuit board. Projections 18, on the underside of each cross-bar member 14, maintain a distance between the cross-bar member and the surface of the printed circuit board so that the printed circuit board conductors do not touch the heat transfer device 10. Two pairs of tapped holes 16, positioned on opposite surfaces of each cross-bar member 14, are counter threaded so as to receive mounting screws 40B and 40C. The mounting screws 40C extend through openings 38 in the printed circuit board 30 and fasten the printed circuit board to the undersurfaces of the cross-bar member 14. In operation, heat is conducted from the blocks 84 to the chassis 50 via the metal plates 82 and the heat transfer devices 10.

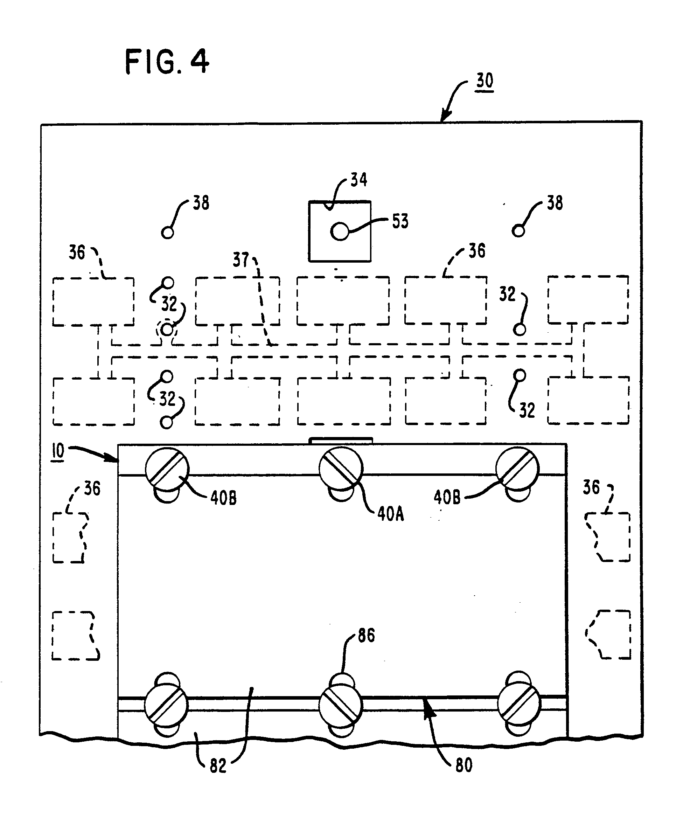

Referring now to Fig. 4, the printed circuit board 30 is shown populated with IC chips 36 on its undersurface. Although not shown in complete detail, for purposes of simplicity, it is understood that conductors 37, for interconnecting the various IC chips to signal and power sources, may be positioned on either or both sides of the printed circuit board 30. In the disclosed configuration, three of the T-shaped heat transfer devices 10 can support a pair of electronic modules 80.

Removal of the fasteners 40A and 40B, associated with a particular electronic module 80, will permit the module to be readily removed from the circuit board 30 simply by pulling the module away from the board. Insertion of a replacement module is accomplished by reversing the removal process. Any soldering or desoldering of a module with respect to the circuit board is thus eliminated. Removal of all of the 40A fasteners will permit the removal of the printed circuit board from the chassis.

While a preferred embodiment of the invention has been shown and described, various other embodiments and modifications thereof will be apparent to persons skilled in the art and thus will fall within the scope of the invention as defined in the following claims.

## Claims

1. A mounting system for an electronic device (84) which is electrically connected to a printed circuit board (30), the system including means (10, 82) for conducting heat from said electronic device to a chassis (50), characterized by a metallic plate (82) to which said electronic device (84) is affixed, said electronic device being positioned between said plate and said printed circuit board (30), and having electrical conductors (85) which extend from said device away from said plate, said printed circuit board (30) being provided with electrical receptacles (32) arranged to receive and to be electrically engaged by said conductors, first and second heat transfer devices (10) each incorporating a cross-bar member (14) and a leg member (12), said cross-bar member of each heat transfer device (10) being disposed between said plate (82) and said board (30), and said leg member of each heat transfer device extending through an opening (34) in said board and abutting against said chassis (50), first fastening means (40C) for attaching said board to said cross-bar member of each heat transfer device, and further fastening means (40A, 40B) for attaching said leg member of each heat transfer device to said chassis, and for attaching said cross-bar member of each heat transfer device to said plate (82), whereby heat is conducted in operation from said electronic device to said chassis via said plate and said first and second heat transfer devices.

2. A mounting system according to claim 1, characterized in that first and second holes (19) are respectively formed in said first and second heat transfer devices (10), each of said holes extending through said cross-bar member (14) and said leg member (12) of the respective heat transfer device, and in that a first one (40A) of said further fastening means extends through said first hole and connects said plate (82) to said chassis (50), and a second one (40A) of said further fastening means extends through said second hole and connects said plate to said chassis.

3. A mounting system according to either claim 1 or claim 2, characterized in that each of said first and second heat transfer devices (10) is in the form of a generally "T" shaped member.

4. A mounting system according to any one of the preceding claims, characterized in that said electronic device (84) is in the form of a block of encapsulated electronic components.

5. A mounting system according to any one of the preceding claims, characterized in that said heat transfer devices (10) are made of metal.

6. A mounting system according to claim 5, characterized in that said cross-bar member (14) of each heat transfer device (10) is provided with at least one projection (18) which serves to space the cross-bar member from said printed circuit board (30) and thereby prevents conductors of said board from contacting the heat transfer device.

7. A mounting system according to any one of the preceding claims, characterized in that said first fastening means (40C) and said further fastening means (40A, 40B) are removable.

8. A mounting system according to any one of the preceding claims, characterized in that said first and second heat transfer devices (10) are respectively arranged to engage with, and extend along, opposed edges of said plate (82).

9. A mounting system according to claim 8, characterized in that at least one of said first and second heat transfer devices (10) also engages a first edge of a further metallic plate (82) to which a further electronic device (84) is affixed, said first edge being positioned adjacent the relevant one of said opposed edges, and a second edge of said further plate, opposite said first edge, being engaged by a third heat transfer device (10) similar to said first and second heat transfer devices, said third heat transfer device being mounted in relation to said board, said chassis (50) and said further metallic plate (82) in a similar manner to that in which said first and second heat transfer devices (10) are mounted in relation to said board, said chassis and the metallic plate mutually associated therewith.

**Patentansprüche**

1. Halterungssystem für eine elektronische Vorrichtung (84), die elektrisch mit einer gedruckten Schaltungsplatte (30) verbunden ist, wobei das System Vorrichtungen (10, 82) zum Leiten von Wärme von der elektronischen Vorrichtung zu einem Chassis (50) aufweist, gekennzeichnet durch eine metallische Platte (82), an der die elektronische Vorrichtung (84) befestigt ist, wobei die elektronische Vorrichtung zwischen der Platte und der gedruckten Schaltungsplatte (30) angeordnet ist und elektrische Leiter (85) aufweist, die sich von der platte weg von der Vorrichtung erstrecken, wobei die gedruckte Schaltungsplatte (30) mit elektrischen Buchsen (32) versehen ist, die angeordnet sind, Leiter aufzunehmen und mit diesen elektrisch in Eingriff zu gehen, erste und zweite Wärmeübertragungsvorrichtungen (10), von denen jede ein Kreuzschienenelement (14) und ein Beinelement (12) aufweist, wobei das Kreuzschienenelement jeder Wärmeübertragungsvorrichtung (10) zwischen der Platte (82) und der Platte (30) angeordnet ist und das Beinelement jeder Wärmeübertragungsvorrichtung sich durch eine Öffnung (34) in der Platte erstreckt und gegen das Chassis (50) anliegt, eine erste Befestigungsvorrichtung (40C) zum Anbringen der Platte an dem Kreuzschienenelement jeder Wärmeübertragungsvorrichtung und weitere Befestigungsvorrichtungen (40A, 40B) zum Anbringen des Beinelements jeder Wärmeübertragungsvorrichtung an dem Chassis und zum Anbringen des Kreuzschienenelements jeder Wärmeübertragungsvorrichtung an der Platte (82), so daß Wärme im Betrieb der elektronischen Vorrichtung zu dem Chassis über die Platte und die erste und zweite Wärmeübertragungsvorrichtung übertragen wird.

2. Halterungssystem nach Anspruch 1, dadurch gekennzeichnet, daß erste und zweite Löcher (19) entsprechend in der ersten und zweiten Wärmeübertragungsvorrichtung (10) ausgebildet sind, wobei jedes Loch sich durch das Kreuzschienenelement (14) und das Beinelement (12) der entsprechenden Wärmeübertragungsvorrichtung erstreckt, und daß ein erstes (40A) der weiteren Befestigungsvorrichtungen sich durch das erste Loch erstreckt und die Platte (82) mit dem Chassis (50) verbindet und daß ein zweites (40A) der weiteren Befestigungsvorrichtungen sich durch das zweite Loch erstreckt und die Platte mit dem Chassis verbindet.

3. Halterungssystem nach Anspruch 1 oder 2, dadurch gekennzeichnet, daß jede der ersten und zweiten Wärmeübertragungsvorrichtung (10) die Form eines durchgehend "T"-förmigen Elements hat.

4. Halterungssystem nach einem der vorhergehenden Ansprüche, dadurch gekennzeichnet, daß die elektronische Vorrichtung (84) die Form eines Blockes von eingekapselten elektronischen Komponenten hat.

5. Halterungssystem nach einem der vorhergehenden Ansprüche, dadurch gekennzeichnet, daß die Wärmeübertragungsvorrichtungen (10) aus Metall hergestellt sind.

6. Halterungssystem nach Anspruch 5, dadurch gekennzeichnet, daß das Kreuzschienenelement (14) jeder Wärmeübertragungsvorrichtung (10) mit zumindest einem Vorsprung (18) versehen ist, der dazu dient, das Kreuzschienenelement von der gedruckten Schaltungsplatte (30) in Abstand zu halten und hierdurch zu verhindern, daß Leiter an der Platte die Wärmeübertragungs-Vorrichtung berühren.

7. Halterungssystem nach einem der vorhergehenden Ansprüche, dadurch gekennzeichnet, daß die erste Befestigungsvorrichtung (40C) und die weiteren Befestigungsvorrichtungen (40A, 40B) entfernbar sind.

8. Halterungssystem nach einem der vorhergehenden Ansprüche, dadurch gekennzeichnet, daß die erste und zweite Wärmeübertragungsvorrichtung (10) entsprechend angeordnet sind, um mit gegenüberliegenden Kanten der Platte (82) in Anlage zu gehen und sich längs derselben zu erstrecken.

9. Halterungssystem nach Anspruch 8, dadurch gekennzeichnet, daß zumindest eine der ersten und zweiten Wärmeübertragungs-Vorrichtungen (10) mit einer ersten Kante einer weiteren metallischen Platte (82) in Anlage ist, an der eine weitere elektronische Vorrichtung (84) befestigt ist, wobei die erste Kante benachbart zur betreffenden der gegenüberliegenden Kanten und wobei eine zweite der ersten Kante gegenüberliegende Kante der weiteren Platte mit einer dritten Wärmeübertragungsvorrichtung (10) in Anlage ist, die gleich der ersten und zweiten Wärmeübertragungsvorrichtung ist, wobei die dritte Wärmeübertragungsvorrichtung in Beziehung zur Schaltungsplatte, dem Chassis (50) und der weiteren metallischen Platte (82) in gleicher Weise angeordnet ist, wie die zweite und dritte Wärmeübertragungsvorrichtung (10) in wechselseitiger Beziehung zur Schaltungsplatte, dem Chassis und der metallischen Platte angeordnet sind.

**Revendications**

1. Système de montage d'un dispositif électronique (84) qui est connecté électriquement à une plaquette à circuit imprimè (30), le système comprenant des moyens (10, 82) destinés à conduire la chaleur dudit dispositif èlectronique à un châssis (50), caractèrisè par une plaque mètallique (82) à laquelle ledit dispositif èlectronique (84) est fixè, ledit dispositif èlectronique ètant positionnè entre ladite plaque et ladite plaquette (30) à circuit imprimè, et comportant des conducteurs èlectriques (85) qui partent dudit dispositif et s'èloignent de ladite plaque, ladite plaquette (30) à circuit imprimé comportant des douilles èlectriques (32) agencèes de façon à recevoir lesdits conducteurs et à être engagèes électriquement par lesdits conducteurs, des premier et second dispositifs (10) de transmission de chaleur comprenant chacun une barre transversale (14) et une jambe (12), ladite barre transversale de chaque dispositif (10) de transmission de chaleur ètant disposèe entre ladite plaque (82) et ladite plaquette (30), et ladite jambe de chaque dispositif de transmission de chaleur passant dans une ouverture (34) de ladite plaquette et butant contre ledit châssis (50), des premiers moyens de fixation (40C) destinés à relier ladite plaquette à ladite barre transversale de chaque dispositif de transmission de chaleur, et d'autres moyens de fixation (40A, 40B) destinès à relier ladite jambe de chaque dispositif de transmission de chaleur audit châssis, et à relier ladite barre transversale de chaque dispositif de transmission de chaleur à ladite plaque (82), de manière que la chaleur soit conduite, en fonctionnement, dudit dispositif électronique audit châssis par l'intermédiaire de ladite plaque et desdits premier et second dispositifs de transmission de chaleur.

2. Système de montage selon la revendication 1, caractérisé en ce que des premier et second trous (19) sont formés respectivement dans lesdits premier et second dispositifs (10) de transmission de chaleur, chacun desdits trous traversant ladite barre transversale (14) et ladite jambe (12) du dispositif de transmission de chaleur respectif, et en ce qu'un premier (40A) desdits autres moyens de fixation passe dans ledit premier trou et relie ladite plaque (82) audit châssis (50), et un second (40A) desdits autres moyens de fixation passe dans ledit second trou et relie ladite plaque audit châssis.

3. Système de montage selon la revendication 1 ou la revendication 2, caractérisé en ce que chacun desdits premier et second dispositifs (10) de transmission de chaleur se présente sous la forme d'un élément de configuration globalementen "T".

4. Système de montage selon l'une quelconque des revendications précédentes, caractérisé en ce que ledit dispositif électronique (84) se présente sous la forme d'un bloc de composants électroniques enrobés.

5. Système de montage selon l'une quelconque des revendications précèdentes, caractérisè en ce que lesdits dispositifs (10) de transmission de chaleur sont rèalisès en mètal.

6. Système de montage selon la revendication 5, caractérisé en ce que ladite barre transversale (14) de chaque dispositif (10) de transmission de chaleur comporte au moins une saillie (18) qui sert à ècarter la barre transversale de ladite plaquette (30) à circuit imprimè et à empêcher ainsi des conducteurs de ladite plaquette d'entrer en contact avec le dispositif de transmission de chaleur.

7. Système de montage selon l'une quelconque des revendications précédentes, caractérisé en ce que lesdits premiers moyens de fixation (40C) et lesdits autres moyens de fixation (40A, 40B) sont amovibles.

8. Système de montage selon l'une quelconque des revendications précédentes, caractérisé en ce que lesdits premier et second dispositifs (10) de transmission de chaleur sont agencès respectivement de façon à s'enclencher avec et à s'ètendre le long de bords opposés de ladite plaque (82).

9. Système de montage selon la revendication 8, caractérisè en ce qu'au moins l'un desdits premier et second dispositifs (10) de transmission de chaleur s'enclenche également avec un premier bord d'une autre plaque métallique (82) à laquelle un autre dispositif électronique (84) est fixé, ledit premier bord étant placé à proximitè immédiate de celui, correspondant, desdits bords opposés, et un second bord de ladite autre plaque, opposé audit premier bord, ètant enclenchè avec un troisième dispositif (10) de transmission de chaleur, similaire auxdits premier et deuxième dispositifs de transmission de chaleur, ledit troisième dispositif de transmission de chaleur ètant montè par rapport à ladite plaquette, audit châssis (50) et à ladite autre plaque mètallique (82) d'une manière similaire à celle suivant laquelle lesdits premier et deuxième dispositifs (10) de transmission de chaleur sont montés par rapport à ladite plaquette, audit châssis et à 1a plaque mètallique qui lui sont mutuellement associés.

FIG.1

# FIG. 2

# FIG. 3

FIG. 4